# EUROPEAN PATENT APPLICATION

(11) **EP 4 826 722 A1**
(43) Date of publication of application: **21.10.2026**
(21) Application number: 25218538.4
(22) Date of filing: 26.11.2025
(51) Int. Cl.: G11C 5/14, G11C 7/04, G11C 11/4074

(54) **MEMORY DEVICES WITH POWER GATING CONTROL**

(30) Priority: 15.04.2025 KR 20250049146
(71) Applicant: Samsung Electronics Co., Ltd., Suwon-si, Gyeonggi-do 16677 (KR)
(72) Inventor: JEON, Jiah, 16677 Suwon-si, Gyeonggi-do (KR); LEE, Minsu, 16677 Suwon-si, Gyeonggi-do (KR)
(74) Representative: Kuhnen & Wacker Patent- und Rechtsanwaltsbüro PartG mbB

(57) **Abstract**

A memory device (200) includes a memory cell array (210) including one or more banks, a power gating switch (231) disposed on a power path for transmitting a power supply voltage (VDD, VPP) inside the memory device (200), a power gating controller (232) configured to turn on or off a power gating operation of the power gating switch (231) based on a temperature of the memory device (200,) and a frequency of an access to the memory device (200), and a control logic circuit (240) configured to provide, to the power gating controller (232), temperature information (Temp) indicating the temperature of the memory device (200) and a counting value indicating the frequency of the access, wherein when the power gating operation is turned on, the power gating switch (231) toggles in response to the access to the memory device (200), and when the power gating operation is turned off, the power gating switch (231) remains turned on regardless of the access to the memory device (200).

## Description

### BACKGROUND

The degree of integration and speed of memory devices which are widely used in high-performance electronic systems are increasing. Memory devices may include a volatile memory or a nonvolatile memory, and may include a memory cell array including a plurality of memory cells and peripheral circuits including various components related to memory operations, such as writing and reading to and from the memory cell array.

Memory devices may include a power path that receives one or more power supply voltages provided from the outside and provides internal power supply voltages to various components provided in a memory device. In addition, in order for memory devices to reduce power consumption caused by leakage current, a solution of placing a power gating switch on a power path and, when the power gating switch is turned off, blocking the supply of power supply voltages to components of a memory device has been proposed.

### SUMMARY

In some cases, there may be a power consumption challenge due to the toggle of the power gating switch. When the driving power of a memory device increases and the size of the power gating switch increases, there may be a problem in which power consumption due to the toggle of the power gating switch further increases. Further, when a memory device temperature is low, even when standby power consumption is small, power consumption may increase due to frequent toggling of the power gating switch.

Some aspects of the present disclosure provide memory devices providing reduced stand-by power due to a leakage current and power due to a power gating operation, and operating methods thereof.

According to some implementations of the present disclosure, there is provided a memory device including a memory cell array including one or more banks, a power gating switch disposed on a power path for transmitting a power supply voltage inside the memory device, a power gating controller configured to turn on or off a power gating operation of the power gating switch based on a temperature of the memory device and a frequency of an access to the memory device, and a control logic circuit configured to provide, to the power gating controller, temperature information indicating the temperature of the memory device and a counting value indicating the frequency of the access, wherein when the power gating operation is turned on, the power gating switch toggles in response to the access to the memory device, and when the power gating operation is turned off, the power gating switch remains turned on regardless of the access to the memory device.

According to some implementations of the present disclosure, there is provided a method of operating a memory device including detecting a temperature of the memory device, performing a counting operation on an access command provided to the memory device, when a result of detecting the temperature and a counting value according to the counting operation satisfy a first condition, turning on a power gating operation of a power gating switch disposed on a power path for transmitting a power supply voltage inside the memory device, and when the result of detecting the temperature and the counting value do not satisfy the first condition, turning off the power gating operation, wherein when the power gating operation is turned on, the power gating switch toggles in response to receiving of the access command, and when the power gating operation is turned off, the power gating switch remains turned on regardless of receiving of the access command.

According to some implementations of the present disclosure, there is provided a memory device including a first memory cell area, a second memory cell area, a first peripheral circuit configured to perform a memory operation on the first memory cell area, a second peripheral circuit configured to perform a memory operation on the second memory cell area, a first power gating switch disposed on a first power path for transmitting a power supply voltage to the first memory cell area and/or the first peripheral circuit, and a second power gating switch disposed on a second power path for transmitting the power supply voltage to the second memory cell area and/or the second peripheral circuit, wherein a power gating operation of the first power gating switch is turned on based on a temperature of the memory device and a frequency of an access to the first memory cell area, and ae power gating operation of the second power gating switch is turned off based on the temperature of the memory device and a frequency of an access to the second memory cell area, the power gating operation of the first power gating switch is turned on, so that the first power gating switch toggles in response to the access to the first memory cell area, and the power gating operation of the second power gating switch is turned off, so that the second power gating switch remains turned on regardless of the access to the second memory cell area.

### BRIEF DESCRIPTION OF THE DRAWINGS

FIG. 1 is a block diagram illustrating an example of a memory system;
FIG. 2 is a block diagram illustrating an example of a memory device;
FIG. 3 is a block diagram illustrating examples of memory device features related to control of a power gating switch;
FIGS. 4A and 4B are waveform diagrams illustrating examples of a generation operation of a counting value and a switching operation of a power gating switch;
FIGS. 5A and 5B are schematic diagrams illustrating examples of memory devices including a high bandwidth memory (HBM);
FIG. 6 is a block diagram illustrating an example of a memory device including control of a power gating switch;
FIGS. 7 and 8 are tables illustrating examples of conditional control of a power gating switch;
FIG. 9 is a flowchart illustrating an example of a method of operating a memory device;
FIG. 10 is a flowchart illustrating an example of a method of operating a memory device;
FIG. 11 is a flowchart illustrating an example of a method of operating a memory device; and
FIG. 12 is a block diagram illustrating an example of a memory device and a memory system including the memory device.

### DETAILED DESCRIPTION

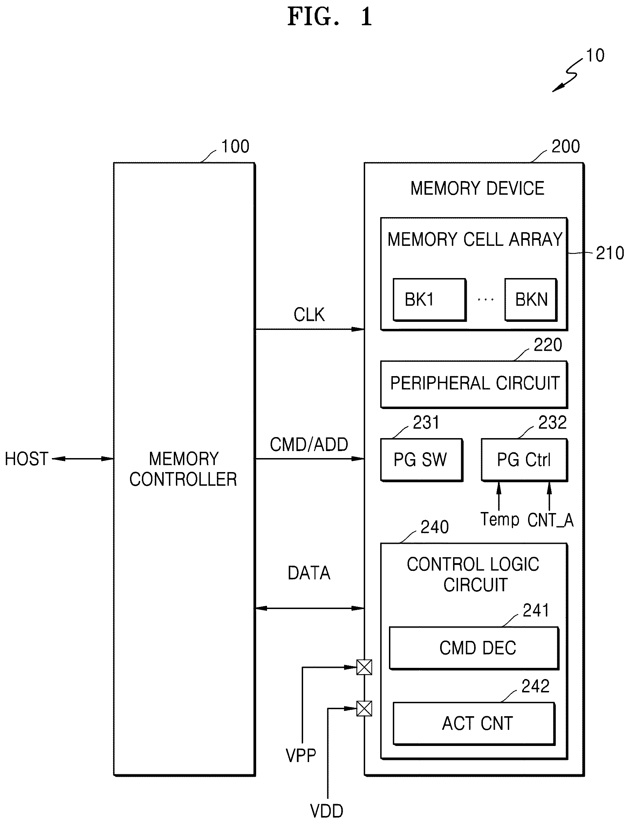

FIG. 1 is a block diagram illustrating an example of a memory system. Referring to FIG. 1, a memory system 10 may include a memory controller 100 and a memory device 200. The memory device 200 may include a memory cell array 210, a peripheral circuit 220, and a control logic circuit 240. In addition, the memory device 200 may receive one or more power supply voltages (or powers) through at least one pin, and, for example, FIG. 1 illustrates that the memory device 200 receives a first power supply voltage VDD and a second power supply voltage VPP through different pins. One or more different power supply voltages may be additionally provided to the memory device 200.

For example, the second power supply voltage VPP may have a higher level than the first power supply voltage VDD. In addition, although not shown in FIG. 1, the memory device 200 may further include a regulator and/or a boosting circuit, and the first power supply voltage VDD and the second power supply voltage VPP may be provided to various components of the memory device 200 through the regulator and/or the boosting circuit. For convenience of description, both power provided to the memory device 200 and power transmitted from the inside of the memory device 200 to the components are referred to as a power supply voltage, but the power transmitted from the inside of the memory device 200, which is distinguished from a power supply voltage provided from the outside, may also be referred to as an internal power supply voltage. In addition, each of the first power supply voltage VDD and the second power supply voltage VPP may be processed with a boosting process and/or a regulating process within the memory device 200, but for convenience of explanation, it is described that each of the first power supply voltage VDD and the second power supply voltage VPP provided from the outside is provided to the components of the inside of the memory device 200.

The memory cell array 210 may include first to Nth banks BK1 to BKN as a plurality of banks. The peripheral circuit 220 may be defined as including various types of components related to a memory operation, and, for example, each of the various types of components may be referred to as a peripheral circuit. For example, the peripheral circuit 220 may include various components such as a row decoder selecting a row of a bank, a column decoder selecting a column, a data input/output circuit, a refresh circuit controlling a refresh operation with respect to memory cells provided in the memory cell array 210, etc. For example, a row address included in a command/address CMD/ADD may be provided to the row decoder, a column address may be provided to the column decoder, and data DATA may be transmitted and received between the memory controller 100 and the memory device 200 through the column decoder and the data input/output circuit.

The memory device 200 may include a power path for transmitting the power supply voltage(s), and the first power supply voltage VDD and the second power supply voltage VPP may be provided to the components within the memory device 200 through different power paths. A power supply voltage having a relatively higher level than a power supply voltage provided to the peripheral circuit 220 may be provided to the memory cell array 210, for example, the second power supply voltage VPP may be provided to the memory cell array 210, and the first power supply voltage VDD may be provided to the peripheral circuit 220.

The memory device 200 may further include a power gating switch 231 and a power gating controller 232. The power gating switch 231 may be disposed on a power path to which the first power supply voltage VDD and/or the second power supply voltage VPP is transmitted. The power gating switch 231 may be disposed on a power path transmitting the first power supply voltage VDD, a power path transmitting the second power supply voltage VPP, and/or one or more other power paths, but for convenience of explanation, it is assumed in the following description that the power gating switch 231 is disposed on the power path transmitting the first power supply voltage VDD.

The power gating controller 232 may control a toggle of the power gating switch 231 by controlling turn-on/turn-off of the power gating switch 231. For example, when the memory device 200 does not operate (or an access command is not provided to the memory device 200), the power gating controller 232 may turn off the power gating switch 231. In addition, in response to the memory device 200 operating (or when an access command is provided to the memory device 200), the power gating controller 232 may turn on the power gating switch 231.

In some implementations, the power gating controller 232 may set a power gating operation of the power gating switch 231 to an on state or an off state. When the power gating operation is set to the on state, the power gating switch 231 may toggle in response to the memory device 200 receiving the access command. On the other hand, when the power gating operation is set to the off state, the power gating switch 231 may remain constant without toggling regardless of receiving of the access command, for example, the power gating switch 231 may remain turned on.

In some implementations, the toggle of the power gating switch 231 according to the receiving of the access command may be performed according to various other methods. For example, while the power gating controller 232 performs a function of setting the power gating operation of the power gating switch 231 to the on state or the off state, another component controlling the toggle of the power gating switch 231 may be further provided in the memory device 200. For example, a control signal for controlling the toggle of the power gating switch 231 may be generated according to a decoding result of the access command, or the memory device 200 may be implemented so that another component receives the decoding result of the access command and control the toggle of the power gating switch 231 based on the decoding result.

In some implementations, the control logic circuit 240 may include a command decoder 241 and an active counter 242. The control logic circuit 240 may include various types of components in the memory device 200, and, for example, may include various components related to the control of a memory operation. In FIG. 1, the active counter 242 is included in the control logic circuit 240, but the configuration is not limited thereto, and the active counter 242 may be disposed outside the control logic circuit 240.

For example, the command decoder 241 may control various internal operations of the memory device 200 based on a decoding result of the command/address CMD/ADD. In addition, the active counter 242 may perform a counting operation on a command provided from the memory controller 100. For example, the active counter 242 may perform the counting operation based on a decoding result of the command decoder 241. The active counter 242 may perform the counting operation based on receiving of at least one of various types of commands. For example, the active counter 242 may perform the counting operation based on receiving of an access command. In some implementations, the command decoder 241 may decode the access command to output an active command (or an internal active command) for activating at least one row of the memory cell array 210, and the active counter 242 may count the number of active commands. In some implementations, the active counter 242 may perform a counting operation of detecting the frequency of the access command provided to the memory device 200. For example, a certain cycle may be set, and the active counter 242 may output a counting value CNT_A during the set cycle.

The memory controller 100 may provide various signals to the memory device 200 through an interface circuit to control memory operations such as a write operation and a read operation. For example, the memory controller 100 may provide a clock signal CLK and the command/address CMD/ADD to the memory device 200 to access the data DATA of the memory cell array 210. In addition, when the memory device 200 includes a dynamic random access memory (DRAM) cell, the command/address CMD/ADD may include a refresh command for refreshing various DRAM-related operations, such as memory cells.

The memory controller 100 may communicate with a host HOST by using various protocols and access the memory device 200 according to a request from the host HOST. In the example of FIG. 1, the host HOST is an external device of the memory controller 100, but the host HOST may be implemented to include the memory controller 100. In the description of the following examples, the memory controller 100 is described as accessing the memory device 200, but it will be understood that a host HOST including the memory controller 100 may access the memory device 200.

In some implementations, the power gating controller 232 may control the power gating switch 231 based on temperature information Temp indicating the temperature of the memory device 200, and based on the counting value CNT_A. For example, the power gating controller 232 may turn off the power gating operation of the power gating switch 231 based on the temperature information Temp, and based on the counting value CNT_A, and accordingly, the power gating switch 231 may remain turned on without toggling. In some implementations, the power gating switch 231 may be controlled according to various policies based on the temperature information Temp and the counting value CNT_A. For example, when the temperature of the memory device 200 is lower than or equal to a certain reference value or the frequency of access to the memory cell array 210 is higher than or equal to a certain reference value, the power gating operation of the power gating switch 231 may be controlled to be turned off.

A large number of transistors may be provided in the memory device 200, and even when the memory device 200 does not operate, a leakage current such as a large number of turn-off currents may be generated, which may increase stand-by power. In this regard, based on the power gating operation of the power gating switch 231 disposed on the power path, when the memory device 200 is not accessed, transmission of the power supply voltage may be blocked, thereby reducing stand-by power consumption.

On the other hand, when the capacity, operating frequency, and bandwidth of the memory device 200 increase, operating power may increase. When the operating power increases, the power gating switch 231 with a larger size may be disposed, and power consumption for toggling the power gating switch 231 may further increase. When the frequency of access to the memory device 200 increases, the toggle of the power gating switch 231 may also increase, and accordingly, power consumption by the power gating switch 231 may increase. In addition, when the temperature of the memory device 200 is relatively low, the leakage current may be low, and even though a stand-by power value is small due to the relatively low temperature of the memory device 200, power consumption may increase due to the increase in the toggle of the power gating switch 231.

However, according to some implementations of the present disclosure, the power gating switch 231 may be controlled based on the temperature information Temp and the counting value CNT_A. For example, when the temperature is low and the access frequency is high, by turning off the power gating operation (or maintaining the power gating switch 231 turned on), unnecessary power consumption by the power gating operation may be reduced or prevented. For example, when the leakage current is relatively small due to the low temperature of the memory device 200, and when the frequency of access to the memory device 200 is higher than the certain reference, the power gating switch 231 may remain turned on without toggling the power gating switch 231.

In some implementations as illustrated in FIG. 1, the number or frequency of access commands is counted, but implementations are not limited thereto, and frequency of receiving various types of commands to provide the power supply voltage to various components of the memory device 200 may instead or additionally be counted and used to control the power gating switch 231. In addition, in the example shown in FIG. 1, the temperature information Temp is generated inside the memory device 200, but, in some implementations, a thermometer may be disposed outside the memory device 200, and/or temperature information Temp from the outside may be provided to the memory device 200.

The memory device 200 may be a dynamic random access memory such as Double Data Rate Synchronous Dynamic Random Access Memory (DDR SDRAM), Low Power Double Data Rate (LPDDR) SDRAM, Graphics Double Data Rate (GDDR) SDRAM, Rambus Dynamic Random Access Memory (RDRAM), etc. However, the memory type is not necessarily limited thereto, and, for example, the memory device 200 may be a nonvolatile memory such as Magnetic RAM (MRAM), Ferroelectric RAM (FeRAM), Phase change RAM (PRAM), Resistive RAM (ReRAM), etc. and the device configurations and processes described herein may be applied to a memory device performing a data retention operation corresponding to refresh.

The memory device 200 may be a single memory chip, or a semiconductor package including two or more memory chips or memory layers. As another example, the memory device 200 may be a memory module in which a plurality of memory chips are mounted on a module board. As another example, FIG. 1 illustrates that the memory controller 100 and the memory device 200 are separated from each other, but the memory device 200 may be implemented as a memory system in which a memory control function and a memory cell array are integrated in a single semiconductor package.

In some implementations, the memory controller 100 may be provided in an application processor (AP), and the AP may be implemented as a system-on-chip (SoC). The SoC may include a system bus to which a protocol having a certain specification bus specification is applied, and may include various types of intellectual properties (IPs) connected to the system bus. As a standard specification for the system bus, the Advanced Microcontroller Bus Architecture (AMBA) protocol of Advanced RISC Machine (ARM) may be applied. Bus types of the AMBA protocol may include Advanced High-Performance Bus (AHB), Advanced Peripheral Bus (APB), Advanced eXtensible Interface (AXI), AXI4, AXI Coherency Extensions (ACE), etc. In addition, another type of protocol such as uNetwork of Sonics Inc., CoreConnect of IBM, and Open Core Protocol of OCP-IP may be applied.

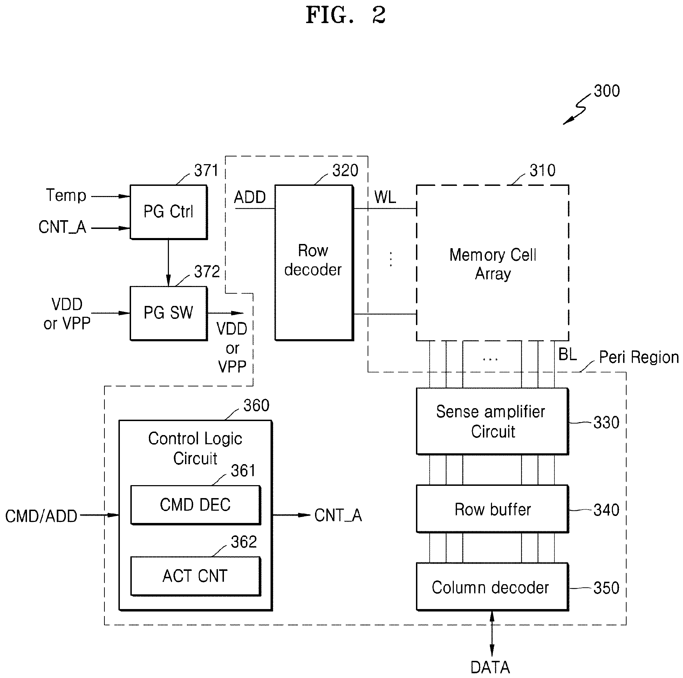

FIG. 2 is a block diagram illustrating an example of a memory device. Referring to FIG. 2, a memory device 300 may include a memory cell array 310 and a peripheral circuit area including one or more peripheral circuits. For example, the peripheral circuits may include a row decoder 320, a sense amplifier circuit 330, a row buffer 340, a column decoder 350, and a control logic circuit 360. The memory cell array 310 may be connected to the row decoder 320 through word lines WL, and may be connected to the column decoder 350 through bit lines BL. In addition, the memory device 300 may further include various peripheral circuits such as an input/output circuit, a storage circuit, etc. in addition to the components shown in FIG. 2. In addition, the memory device 300 may further include a power gating controller 371 and a power gating switch 372.

It will be understood that the description provided for FIG. 1 and elements thereof can be applied to FIG. 2 and corresponding/similar elements thereof, except where noted otherwise or suggested otherwise by context.

The command/address CMD/ADD for data access may be received from a memory controller, and the address ADD may include a row address indicating a row of the memory cell array 310. The row decoder 320 may activate a row corresponding to the row address, and the activated row data DATA may be stored in and amplified by the sense amplifier circuit 330. In addition, data sensed from the sense amplifier circuit 330 may be temporarily stored in the row buffer 340, and the data stored in the row buffer 340 may be provided to the memory controller through the column decoder 350.

The control logic circuit 360 may include a command decoder 361 and an active counter 362, and the command decoder 361 may decode the command/address CMD/ADD from the memory controller, and the active counter 362 may output the counting value CNT_A obtained by counting the number or frequency of access commands with respect to the memory cell array 310.

The power gating switch 372 may be disposed on a power path, for example, on a power path for transmitting the first power supply voltage VDD or the second power supply voltage VPP to various components inside the memory device 300. The power gating controller 371 may receive the temperature information Temp and the counting value CNT_A, and control the power gating switch 372 based on the temperature information Temp and the counting value CNT_A. For example, assuming that the first power supply voltage VDD is provided to the peripheral circuit and the second power supply voltage VPP is provided to the memory cell array 310, the power gating switch 372 may provide or block the first power supply voltage VDD to or from the peripheral circuit based on the power gating operation, or the power gating switch 372 may provide or block the second power supply voltage VPP to or from the memory cell array 310 based on the power gating operation. In some implementations, the power gating switch 372 may be disposed on the power path for transmitting the first power supply voltage VDD, and the power gating switch 372 may be disposed on the power path for transmitting the second power supply voltage VPP. In addition, the control of the power gating switch 372 may be applied to the power path for transmitting the first power supply voltage VDD and/or the power path for transmitting the second power supply voltage VPP.

As shown in FIG. 2, assuming that the power gating switch 372 is disposed in correspondence with the first power supply voltage VDD, the power gating switch 372 may provide the first power supply voltage VDD to at least one peripheral circuit. For example, when the power gating operation of the power gating switch 372 is turned off based on the temperature information Temp and the counting value CNT_A, the provision of the first power supply voltage VDD to at least one peripheral circuit may be maintained regardless of receiving of an access command. When the power gating operation of the power gating switch 372 is turned on based on the temperature information Temp and the counting value CNT_A, the switching operation of the power gating switch 372 may be controlled so that the power gating switch 372 toggles in response to the receiving of the access command. For example, when the temperature of the memory device 300 is low and the frequency of access to the memory cell array 310 is high, the power gating operation of the power gating switch 372 may be turned off.

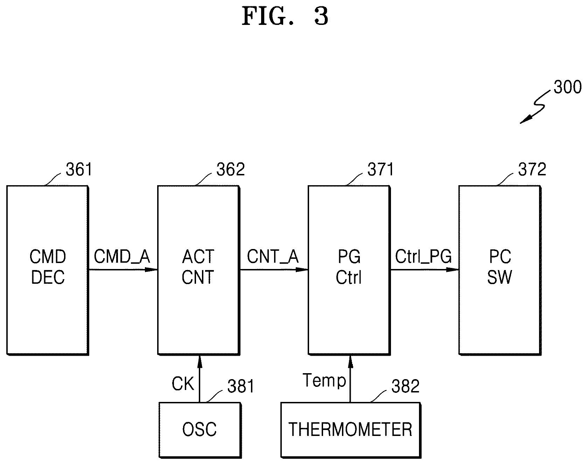

FIG. 3 is a block diagram illustrating examples of memory device features related to control of a power gating switch.

Referring to FIGS. 2 and 3, the memory device 300 may include the command decoder 361, the active counter 362, the power gating controller 371, the power gating switch 372, an oscillator 381, and a thermometer 382, and the command decoder 361 may receive a command provided from an external device (e.g., a memory controller or a host), decode the command, and output an internal command. For example, the command decoder 361 may decode access commands such as write and read from a memory controller to generate an active command CMD_A for activating at least one row of the memory cell array 310 as an internal command.

The active counter 362 may perform a counting operation on a decoding result of the command decoder 361, and, for example, may perform the counting operation on the active command CMD_A. The oscillator 381 may output a clock signal CK (or a pulse signal) having a certain cycle or periodicity, and the active counter 362 may perform the counting operation based on the clock signal CK output from the oscillator 381. For example, the active counter 362 may count the number of the active commands CMD_A received for one or more cycles or periods of the clock signal CK, and the counting value CNT_A may indicate the frequency of access to the memory device 300.

The counting value CNT_A output from the active counter 362 may be provided to the power gating controller 371. In addition, the thermometer 382 may detect a temperature inside the memory device 300 and provide the temperature information Temp to the power gating controller 371. The power gating controller 371 may provide a power gating control signal Ctrl_PG to the power gating switch 372 based on the counting value CNT_A and the temperature information Temp. The power gating control signal Ctrl_PG may have a value for setting the power gating operation of the power gating switch 372 to an on state or an off state.

When the power gating operation of the power gating switch 372 is turned on according to the power gating control signal Ctrl_PG, the power gating switch 372 may be controlled to toggle whenever access to the memory device 300 is performed. On the other hand, when the power gating operation of the power gating switch 372 is turned off according to the power gating control signal Ctrl_PG, the power gating switch 372 may be controlled to remain turned on regardless of the access to the memory device 300.

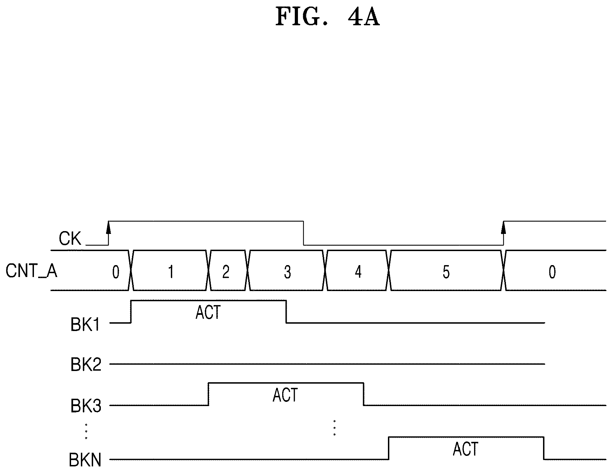

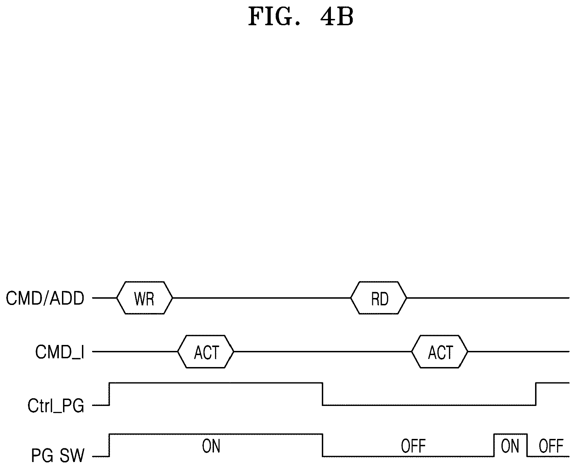

FIGS. 4A and 4B are waveform diagrams illustrating examples of a generation operation of the counting value CNT_A and a switching operation of a power gating switch.

Referring to FIGS. 2 to 4A, the memory cell array 310 may include a plurality of banks (e.g., the first to Nth banks BK1 to BKN), and an access command with respect to the memory cell array 310 is received, and thus at least one row of each of the first to Nth banks BK1 to BKN may be activated. As an example of this operation, an active period of one bank may overlap an active period of another bank, and accordingly, there may be a period in which at least two banks of the memory cell array 310 are activated together.

The clock signal CK output from the oscillator 381 has a certain cycle, and in FIG. 4A, the number of activating the first to Nth banks BK1 to BKN is counted during one cycle of the clock signal CK. For example, the first bank BK1 is activated during the cycle of the clock signal CK, and thus the counting value CNT_A may increase to 1, and the third bank BK3 is activated, and thus the counting value CNT_A may increase to 2. In addition, the counting value CNT_A may increase during the cycle of the clock signal CK, and the Nth bank BKN is activated, and thus the counting value CNT_A may increase to 5. In the above example, the counting value CNT_A is generated during one cycle of the clock signal CK, but the counting process is not limited thereto, and the number of activations during two or more cycles of the clock signal CK may be counted.

Meanwhile, referring to FIG. 4B, a power gating operation of the power gating switch 372 may be set to an on state or an off state according to a logic state of the power gating control signal Ctrl_PG. When the logic state of the power gating control signal Ctrl_PG has a first value, the power gating operation of the power gating switch 372 may be turned off, and the power gating switch 372 may remain turned on regardless of receiving of an access command (e.g., a write command WR) from a memory controller or the generation of an active command ACT as an internal command CMD_I based on a decoding result. On the other hand, when the logic state of the power gating control signal Ctrl_PG has a second value, the power gating operation of the power gating switch 372 may be turned on, and the power gating switch 372 may toggle in response to receiving an access command (e.g., a read command RD) from the memory controller or generating the active command ACT based on the decoding result.

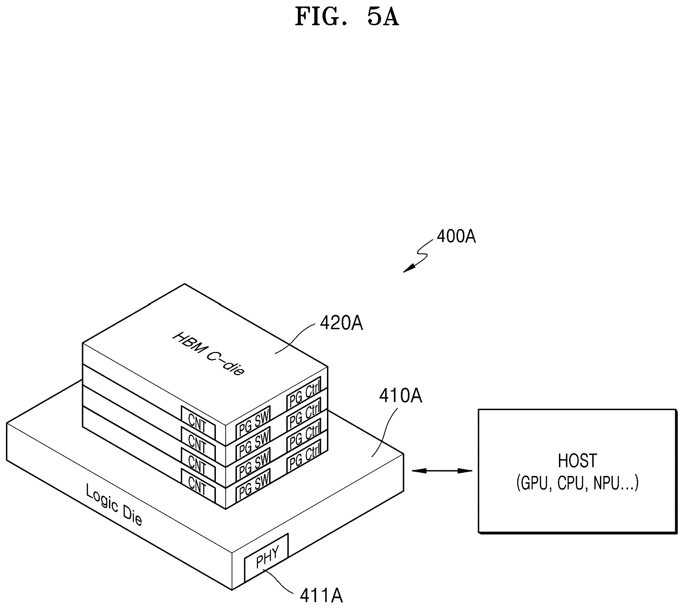

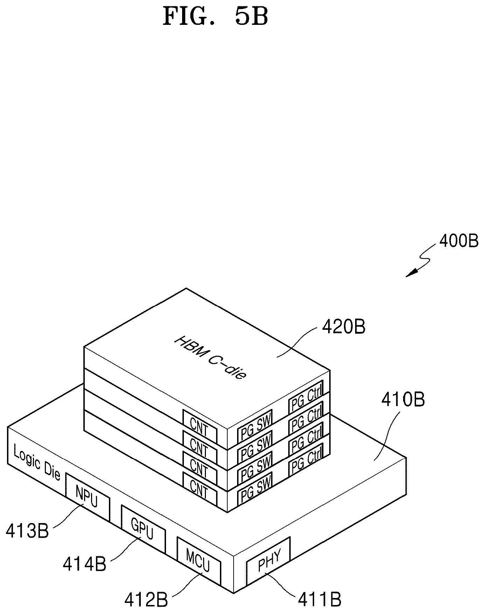

FIGS. 5A and 5B are schematic diagrams illustrating examples of memory devices including a high bandwidth memory (HBM).

Referring to FIG. 5A, a memory device 400A may include the HBM. For example, the HBM may include a logic die 410A and a plurality of core dies 420A stacked in a 3D shape thereon. The logic die 410A may itself function as a host, or may control a memory operation on the plurality of core dies 420A in response to a request from an external host. For example, the external host may include a central processing unit (CPU), a graphics processing unit (GPU), a neural processing unit (NPU), an acceleration processing unit (APU), an AP, etc. The logic die 410A may be electrically connected to a printed circuit board (PCB) through a plurality of bumps or connection terminals, and the memory device 400A may be implemented as a semiconductor package including the PCB.

The logic die 410A may include a physical PHY area 411A, and the physical PHY area 411A may provide communication between the plurality of core dies 420A and an external host. Each of the plurality of core dies 420A may include one or two or more channels, and each channel may include a memory cell array. Peripheral circuits performing data write/read operations on the memory cell array may be disposed for each channel. That is, access to the two or more channels may be controlled independently of each other.

The logic die 410A may include at least one peripheral circuit for accessing the memory cell array included in the plurality of core dies 420A based on the control of the external host. A control signal from the logic die 410A may be provided to the plurality of core dies 420A through a plurality of through silicon vias (TSVs), and data may be transmitted between the logic die 410A and the plurality of core dies 420A through the plurality of TSVs.

Various components for power gating control may be disposed in the logic die 410A and the plurality of core dies 420A. For example, a control logic circuit, an oscillator, a thermometer, a power gating switch PG SW, and a power gating controller PG Ctrl as described throughout this disclosure may be disposed in the logic die 410A and the plurality of core dies 420A.

As an example, the power gating switch PG SW and the power gating controller PG Ctrl may be disposed in a channel of each of the core dies 420A to control transmission of a power supply voltage on a power path of each channel. In addition, the active counter CNT described above may be provided for each channel, thereby outputting a counting value indicating the access frequency of the corresponding channel. In addition, thermometers may be disposed in various forms/arrangements. For example, the thermometers are disposed in the respective core dies, and thus temperature information from the temperatures sensor may be provided together to at least two channels of the respective core dies. As another example, the thermometers are disposed in the respective channels, and thus two or more thermometers may be implemented in any one core die.

In addition, an oscillator may be disposed on the logic die 410A to provide a clock signal to the plurality of core dies 420A, or the oscillator may be disposed on each of the core dies 420A. Similarly, command decoders may be implemented in the respective channels, and each command decoder may be disposed in the logic die 410A to provide a command decoding result to the corresponding channel of each of the core dies 420A, or the memory device 400A may be implemented so that the command decoder is disposed in the corresponding channel in each of the core dies 420A.

In some implementations, the power gating operation of the power gating switch PG SW may be set to an on state or an off state for each channel, and accordingly, the power gating operation of the power gating switch PG SW may be set to the on state in some channels, while the power gating operation of the power gating switch PG SW may be set to the off state in the other channels.

Meanwhile, referring to FIG. 5B, a memory device 400B may include a logic die 410B and a plurality of core dies 420B stacked thereon, and the logic die 410B may include a physical PHY area 411B and a memory control unit 412B. In addition, the logic die 410B may perform a function of host and thus include various processing devices such as an NPU 413B and a GPU 414B, and, although not shown in FIG. 5B, other various types of processing devices that provide data access requests may be further included in the logic die 410B.

The power gating control configurations described above may also be applied to the memory device 400B shown in FIG. 5B, and accordingly, each of the plurality of core dies 420B may include the active counter CNT, the power gating switch PG SW, and the power gating controller PG Ctrl. Based on the temperature and access frequency of each channel provided in the memory device 400B, a power gating operation of the power gating switch PG SW disposed in each of the plurality of core dies 420B may be set to an on state or an off state.

The device arrangements and configurations shown in FIGS. 5A and 5B are only examples, and the components may be disposed in other various forms. For example, the memory devices 400A and 400B may be implemented such that at least one of the active counter CNT, the power gating switch PG SW, or the power gating controller PG Ctrl is disposed on the logic die 410A or 410B.

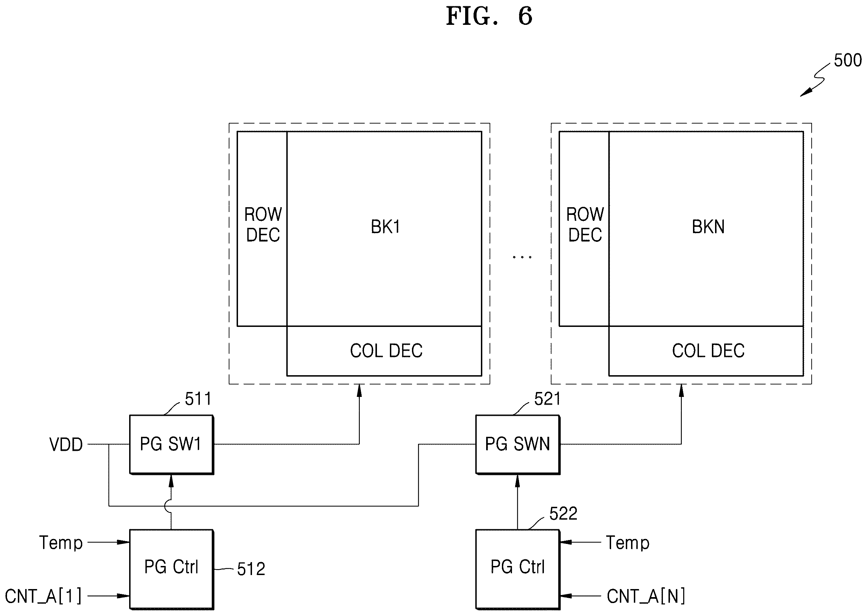

FIG. 6 is a block diagram illustrating an example of controlling a power gating switch for each bank. Referring to FIG. 6, a memory device 500 may include the first to Nth banks BK1 to BKN as a plurality of banks, and a row decoder and a column decoder may be disposed as peripheral circuits in response to each of the first to Nth banks BK1 to BKN. Although not shown in FIG. 6, the memory device 500 may further include various other peripheral circuits in relation to a memory operation on the first to Nth banks BK1 to BKN, e.g., as described with respect to FIGS. 1 to 3.

In some implementations, the memory device 500 may include at least two power gating controllers and power gating switches. In FIG. 6, a gating controller and a power gating switch are disposed in correspondence with each of the first to Nth banks BK1 to BKN, but configurations are not limited thereto. For example, a bank group including at least two banks may be defined, and the memory device 500 may be implemented so that the power gating controller and the power gating switch are disposed in correspondence with the bank group. In addition, in the example shown in FIG. 6, power gating is applied to the first power supply voltage VDD, but power gating may instead or additionally be applied to the second power supply voltage VPP and/or other power supply voltages.

The first power supply voltage VDD may be provided to each of the first bank BK1 and the Nth bank BKN (or peripheral circuits related to the first bank BK1 and the Nth bank BKN) through a power gating switch disposed on a power path in the memory device 500, and, for example, may be provided to each of the row decoder and the column decoder. For example, a first power gating switch 511 performing power gating on the first power supply voltage VDD provided to the first bank BK1 and a second power gating switch 521 performing power gating on the first power supply voltage VDD provided to the Nth bank BKN may be disposed, and a first power gating controller 512 controlling the first power gating switch 511 and a second power gating controller 522 controlling the second power gating switch 521 may be provided in the memory device 500. The power gating controllers 512, 522 can be referred to as being included in a same power gating controller.

In some implementations, the first power gating switch 511 and the second power gating switch 521 may be separately controlled. As an example of operation, the temperature information Temp may be commonly provided to the first power gating controller 512 and the second power gating controller 522. In addition, an active counter is separately disposed for each bank or bank group, and thus an active command with respect to the first bank BK1 and an active command with respect to the Nth bank BKN may be separately counted. In the case where a command decoder is commonly disposed with respect to the first bank BK1 and the Nth bank BKN, when the command decoder decodes the access command with respect to the first bank BK1, a first counting value CNT_A[1] with respect to the first bank BK1 may selectively increase, and when the command decoder decodes the access command with respect to the Nth bank BKN, a second counting value CNT_A[N] for the Nth bank BKN may selectively increase.

The first power gating controller 512 may control the first power gating switch 511 based on the temperature information Temp and the first counting value CNT_A[1], and the second power gating controller 522 may control the second power gating switch 521 based on the temperature information Temp and the second counting value CNT_A[N].

When the memory device 500 includes a plurality of banks, access frequencies may be different for each bank at a preset cycle. For example, values obtained by counting the active commands with respect to the first to Nth banks BK1 to BKN may be different for each bank, and the first counting value CNT_A[1] with respect to the first bank BK1 may be greater than the second counting value CNT_A[N] f with respect to the Nth bank BKN. In this regard, the power gating operation of the first power gating switch 511 is turned off, and the first power gating switch 511 remained turned on, and thus the first power supply voltage VDD may be provided to peripheral circuits related to the first bank BK1 and/or the first bank BK1 regardless of an access operation on the first bank BK1. On the other hand, the power gating operation of the second power gating switch 521 is turned on, and thus the second power gating switch 521 may toggle when access to the Nth bank BKN is performed.

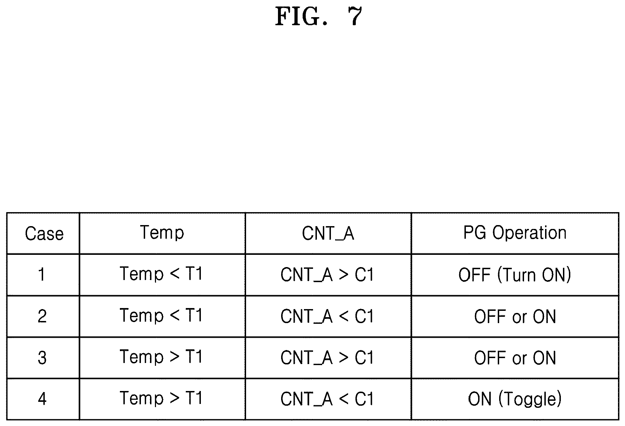

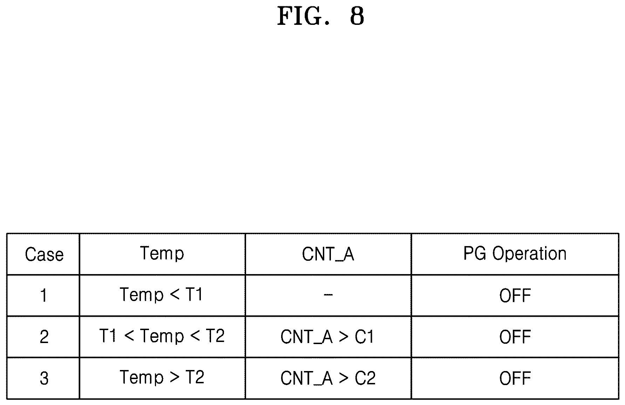

FIGS. 7 and 8 are tables illustrating examples of conditional control of a power gating switch.

As described above, when the temperature of a memory device is low, a leakage current may be small, and accordingly, the power consumption of stand-by power may be small compared to the power consumption due to the toggle of a power gating switch. On the other hand, when the frequency of access to the memory device is high, power consumption due to the toggle of the power gating switch may further increase.

In some implementations, at least one reference value may be set for each of temperature information and a counting value in relation to the control of the power gating switch. A power gating controller may perform a control operation on the power gating switch based on a result of comparing each of the temperature information and the counting value with the at least one reference value.

Referring to FIG. 7, a first temperature reference value T1 may be set in relation to the temperature information, and a first counting reference value C1 may be set in relation to the counting value CNT_A. As in case 1, when the temperature of the memory device is lower than the first temperature reference value T1 and the counting value CNT_A is greater than the first counting reference value C1, the power gating operation of the power gating switch may be turned off, and the power gating switch may remain turned on. On the other hand, as in case 4, when the temperature of the memory device is higher than the first temperature reference value T1 and the counting value CNT_A is lower than the first counting reference value C1, the power gating operation of the power gating switch may be turned on, and the power gating switch may toggle in response to the access command being provided to the memory device.

On the other hand, as in case 2, when the temperature of the memory device is lower than the first temperature reference value T1 and the counting value CNT_A is lower than the first counting reference value C1, and, as in case 3, when the temperature of the memory device is higher than the first temperature reference value T1 and the counting value CNT_A is greater than the first counting reference value C1, the power gating operation of the power gating switch may be turned on or off according to various policies. For example, during a test process of the memory device, stand-by power consumption according to temperature and/or power consumption due to the toggle of the power gating switch may be tested, and based on the test, various policies based on the temperature information Temp and the counting value CNT_A may be set.

For example, when the power consumption due to the toggle of the power gating switch is relatively small, the power gating operation of the power gating switch may be set to be turned on in case 2 and/or case 3. Accordingly, the power gating switch may toggle in response to the access command being provided to the memory device. On the other hand, when the leakage current characteristics of transistors are tested to be acceptable, the power gating operation of the power gating switch may be set to be turned off in case 2 and/or case 3 described above. Accordingly, the power gating switch may remain turned on regardless of the receiving of the access command.

The above-described configuration is an example, and the scope of this disclosure is not limited thereto. The power gating operation may be set according to various policies, such as comparing the stand-by power consumption with power consumed by power gating in various conditions based on test results of the memory device, determining whether the power gating operation is applied in each of conditions based on comparison results, etc.

Referring to FIG. 8, a temperature range of the memory device is determined, and conditions of the counting value for turning off the power gating operation of the power gating switch are differently set based on the temperature range. For example, the lower the temperature of the memory device, the less the impact of stand-by power consumption, and thus even when the access frequency is low, the power gating operation of the power gating switch may be turned off and the power gating switch may remain turned on. On the other hand, the higher the temperature of the memory device, the more the stand-by power consumption, and thus the power gating operation of the power gating switch may be turned on, but when the power consumed by power gating increases significantly compared to the stand-by power consumption according to a significant increase in the access frequency, the power gating operation of the power gating switch may be turned off.

As shown in FIG. 8, the first and second temperature reference values T1 and T2 are set as at least one temperature reference value related to temperature, and the first and second counting reference values C1 and C2 are set as reference values related to the counting value. The second temperature reference value T2 may be greater than the first temperature reference value T1, and the second counting reference value C2 may be greater than the first counting reference value C1.

As in case 1, when the temperature of the memory device is lower than the first temperature reference value T1, the power gating operation of the power gating switch may be set to be turned off even when the frequency of access to the memory device is relatively low. As an example, FIG. 8 illustrates that the power gating operation of the power gating switch is turned off regardless of the counting value CNT_A when the temperature of the memory device is lower than the first temperature reference value T1. However, configurations are not limited thereto, and a certain counting reference value for turning off the power gating operation of the power gating switch may be set even when the temperature of the memory device is lower than the first temperature reference value T1.

On the other hand, when the temperature of the memory device is higher than the first temperature reference value T1 and lower than the second temperature reference value T2 as in case 2, the power gating operation of the power gating switch may be set to be turned off when the frequency of access of the memory device is relatively high compared to case 1. For example, the power gating operation of the power gating switch may be selectively turned off when the counting value CNT_A is greater than the first counting reference value C1. In some implementations, when CNT_A < C1 and T1 < Temp < T2, the power gating operation may be turned on.

In addition, when the temperature of the memory device is higher than the second temperature reference value T2, as in case 3, the power gating operation of the power gating switch may be selectively turned off when the counting value CNT_A is greater than the second counting reference value C2. The second counting reference value C2 may be greater than the first counting reference value C1, and accordingly, the higher the temperature of the memory device, the higher the reference of the counting value CNT_A for turning off the power gating operation of the power gating switch. In some implementations, when CNT_A < C2 and Temp > T2, the power gating operation may be turned on.

The configuration shown in FIG. 8 is an example, and the power gating operation may be set based on various policies. For example, based on the test results of the stand-by power consumption and the power consumed by the power gating operation, temperature reference values and counting reference values may be set in various ways, and the temperature range of the memory device for turning on or off the power gating operation and the conditions of the counting value corresponding thereto may be set in various ways.

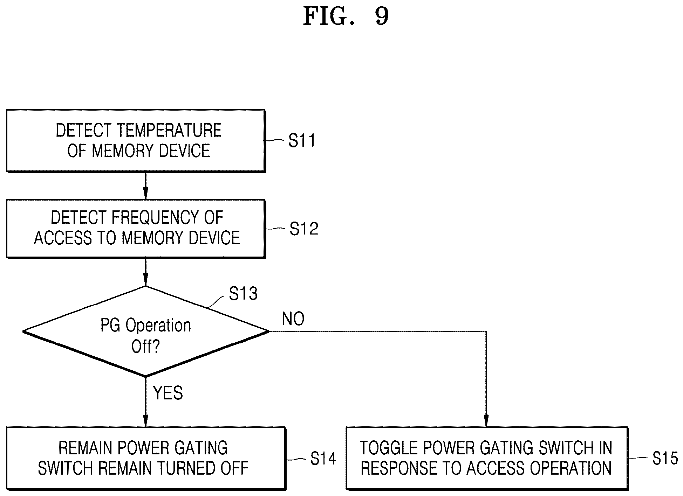

FIG. 9 is a flowchart illustrating an example of a method of operating a memory device.

Referring to FIG. 9, the memory device may include a power path for transmitting an external power supply voltage to various internal components (e.g., peripheral circuits), a power gating switch controlling the transmission of power supply voltage disposed on the power path, and a power gating controller controlling a power gating operation of the power gating switch to be turned on or off.

The memory device may detect the temperature of the memory device through temperature information from an internal thermometer or temperature information provided from the outside (S11), and may detect the frequency of access to the memory device through a counting operation (e.g., a counting operation on a decoding result of an active command) on a command provided to the memory device (S12).

The power gating controller may determine whether to turn off the power gating operation (or a toggling operation of the power gating switch) based on a temperature detection result and detection result of the access frequency (S13), e.g., as described with respect to FIGS. 7 and 8. As a result of determination, when the detection result satisfies a certain condition, the power gating operation of the power gating switch may be turned off, and accordingly, the power gating switch may remain turned off regardless of an access operation on the memory device (S14). On the other hand, when the detection result does not satisfy the certain condition, the power gating operation of the power gating switch may be turned on, and accordingly, the power gating switch may toggle in response to the access operation being performed on the memory device (S15).

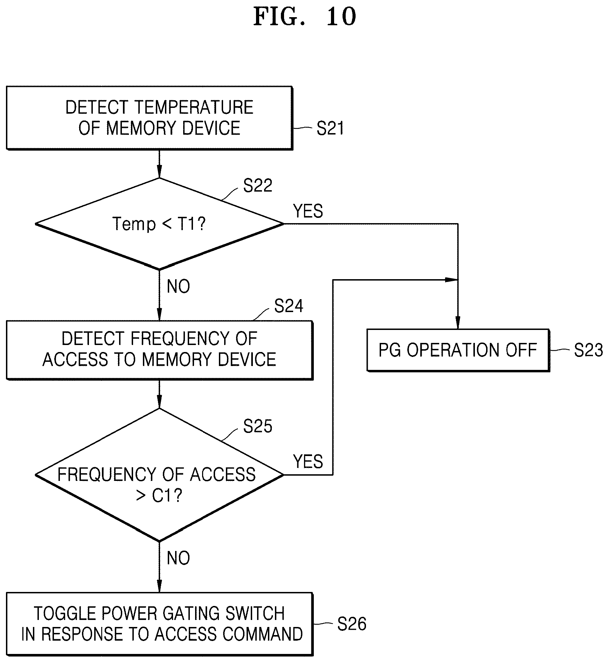

FIG. 10 is a flowchart illustrating another example of a method of operating a memory device. In an example shown in FIG. 10, a priority is given to temperature information in relation to a condition of turning off a power gating operation.

Referring to FIG. 10, the temperature of the memory device may be detected (S21), and it may be determined whether a value of the temperature information Temp is less than the first temperature reference value T1 (S22). When the value of the temperature information Temp of the memory device is less than the first temperature reference value T1, a power gating operation (or a toggling operation of a power gating switch) of the power gating switch may be turned off regardless of the frequency of access to the memory device, and the power gating switch may remain turned on (S23).

On the other hand, when the value of the temperature information Temp of the memory device is greater than or equal to the first temperature reference value T1, the frequency of access to the memory device may be detected (S24), and toggling of the power gating switch may be set to turned on or off based on a detection result of the access frequency. For example, when the frequency of access to the memory device exceeds the first counting reference value C1, in order to reduce power consumption due to frequent toggling of the power gating switch, the power gating operation of the power gating switch may be turned off according to operation S23. On the other hand, when the frequency of access to the memory device is less than or equal to the first counting reference value C1, the power gating operation of the power gating switch may be turned on, and accordingly, the power gating switch may toggle in response to an active command (S26).

In the example shown in FIG. 10, the priority is given to the temperature of the memory device, but configurations are not limited thereto. For example, when a priority is given to the frequency of access to the memory device, the power gating operation of the power gating switch may be set to be turned off when the access frequency exceeds a certain reference value. On the other hand, when the access frequency does not exceed the certain reference value, the power gating operation of the power gating switch may be selectively set to be turned off when the temperature of the memory device is less than a specific reference value.

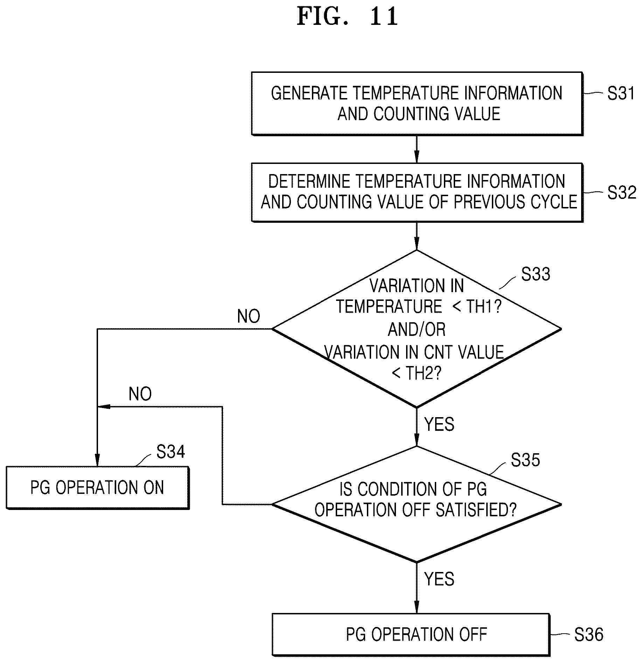

FIG. 11 is a flowchart illustrating another example of a method of operating a memory device. In FIG. 11, a power gating operation is controlled based on a change in the temperature and/or the frequency of access to the memory device.

In the memory device, the change in the temperature and the change in the access frequency may occur in various operating environments, and the temperature may change rapidly in a special circumstance and then return, or the access frequency may also increase intensively at a specific time. In this regard, in some implementations, the power gating operation is set by determining a change in the temperature information and/or the counting value, thereby reducing or preventing setting of the power gating operation from being unnecessarily frequently changed, and accordingly, the power gating operation may be efficiently and effectively set in accordance with the operating environment of the memory device. For example, while the power gating operation is turned on due to the low frequency of access to the memory device, the power gating operation may remain turned on without being turned off again even though the frequency of access to the memory device temporarily increases.

Referring to FIG. 11, the temperature information and the counting value of the memory device may be generated as described above (S31), and the generated temperature information and counting values may be stored in a storage circuit in the memory device. The memory device may set an on/off state of the power gating operation based on the temperature information and the counting value generated in a current cycle, and may determine temperature information and a counting value generated and stored in at least one previous cycle (S32).

Through temperature information and counting values in a plurality of cycles, a variation in the temperature and a variation in the counting value may be determined. The variation in the temperature may indicate a change in the temperature of the memory device over time, and the variation in the counting value may indicate a change in the frequency of access to the memory device.

In some implementations, when a low temperature is maintained for a certain period of time or a large value of access frequency is maintained for a certain period of time, the memory device may be controlled to turn off the power gating operation. As an example, a first threshold value TH1 related to the variation in the temperature may be set, a second threshold value TH2 related to the variation in the counting value may be defined, a currently determined variation in the temperature may be compared with the first threshold value TH1, and a currently determined variation in the counting value may be compared with the second threshold value TH2 (S33).

Based on comparison results, the power gating operation may be turned off based on various policies. For example, when the variation in the temperature amount is less than the first threshold value TH1 or the variation in the counting value is less than the second threshold value TH2, it may be determined that the temperature or the counting value of the memory device has not changed rapidly, and in this case, the power gating operation may be turned on or off based on the temperature and the counting value of the memory device detected in the current cycle according to the above-described examples of, for example, FIGS. 7 to 10. When the variation in the temperature is less than the first threshold value TH1 and the variation in the counting value is less than the second threshold value TH2, a determination result in operation S33 may correspond to 'YES'.

When the determination result in operation S33 is 'YES', it may be determined whether the temperature and the counting value of the memory device satisfy conditions for turning off the power gating operation as described above (e.g., with respect to FIGS. 7 to 10) (S35), and the power gating operation may be turned on (S34) or the power gating operation may be turned off (S36) according to the determination result.

Meanwhile, in operation S33, when the variation in the temperature is greater than the first threshold value TH1 or the variation in the counting value is greater than the second threshold value TH2, the determination result in operation S33 may correspond to 'NO'. Alternatively, in operation S33, when the variation in the temperature is greater than the first threshold value TH1 and the variation in the counting value is greater than the second threshold value TH2, the determination result in operation S33 may correspond to 'NO'. When the determination result in operation S33 is 'NO', it is determined that the temperature or the counting value of the memory device has currently rapidly changed, and accordingly, the power gating operation may remain turned on without being turned off.

Accordingly, when the temperature or the counting value of the memory device rapidly changes, it may be determined whether the changed temperature or counting value is maintained without immediately changing the setting of the power gating operation in response thereto. For example, when the temperature or the counting value does not change significantly again after a sudden change in the temperature or the counting value, it may be determined that a variation in the temperature or a variation in the counting value of the memory device determined in a next cycle is less than a threshold value, and the power gating operation of the power gating switch may be changed to be turned on or off based on the temperature or the counting value of the memory device detected in the next cycle.

In the example of FIG. 11, when the on state of the power gating operation is defined as a default state and when the variation in the temperature or the variation in the counting value of the memory device exceeds the threshold value, the power gating operation is set to be the on state, but this control may be modified in various ways. For example, when the variation in the temperature or the variation in the counting value of the memory device exceeds the threshold value, the memory device may be implemented so that the power gating operation set in the previous cycle remains unchanged.

Further, in some implementations according to the example of FIG. 11, the variations in the temperature and the counting value is determined based on the detection values of the current cycle and the previous cycle, but this process may be modified in various ways. For example, an abnormal temperature change and counting value change of the memory device may be detected through access commands provided to the memory device and various processing operations on the temperature information detected from the memory device, and various policies for setting the power gating operation of the power gating switch may be applied based on detection results.

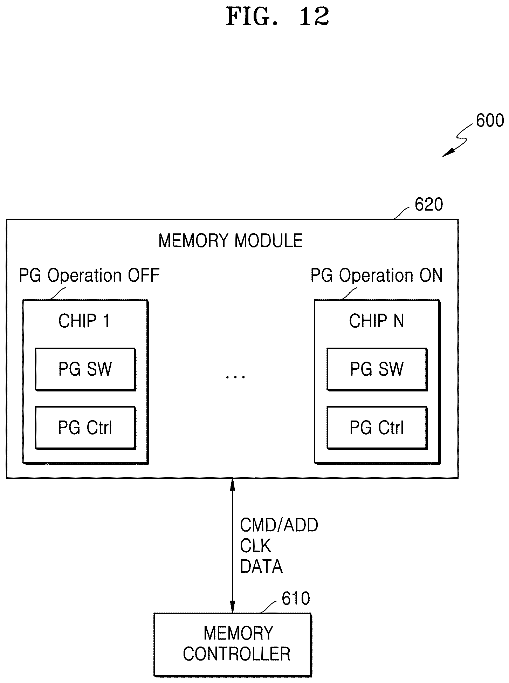

FIG. 12 is a block diagram illustrating an example of a memory device and a memory system including the memory device.

Referring to FIG. 12, a memory system 600 may include a memory controller 610 and a memory device 620, and the memory device 620 may include a plurality of memory chips. In the example shown in FIG. 12, the memory device 620 corresponds to a memory module in which the plurality of memory chips are mounted, but memory configurations within the scope of this disclosure are not limited thereto, and the memory device 620 may be implemented in the form of a multi-chip package including the plurality of memory chips, etc.

The memory module may be implemented in the form of a single in-line memory module (SIMM) or a dual in-line memory module (DIMM), and when the memory module is implemented as the DIMM, memory devices may be mounted on both sides of a module board. The memory controller 610 may provide a clock signal, a command/address, and data to the plurality of memory chips through wirings on the module board.

Each memory chip may include the memory device shown in FIGS. 1 to 11. Each memory chip may include the power gating switch PG SW transmitting a power supply voltage, the power gating controller PG Ctrl controlling a power gating operation of the power gating switch PG SW, a thermometer detecting a temperature, a command decoder decoding a command/address, and an active counter counting the number of actives.

In some implementations, different temperatures may be detected for each memory chip, and/or access frequencies may be different for each memory chip. Accordingly, the power gating switches PG SW of the memory chips may be controlled differently, and power gating operations of some memory chips may be set to an on state, while power gating operations of the other memory chips may be set to an off state.

Further, various reference values and threshold values as described with respect to FIGS. 1 to 11 may be set differently for each memory chip. For example, the power consumption of the stand-by power and the power consumed by the power gating switch may be tested during a test process of the plurality of memory chips, and based on this, optimized reference values and threshold values may be set for each chip. For example, a first operation condition for turning off the power gating operation in a first memory chip CHIP 1 and an Nth operation condition for turning off the power gating operation in an Nth memory chip CHIP N may be defined, and reference values (e.g., a temperature reference value and/or a counting reference value) of the first operation condition may be different from reference values of the Nth operation condition. Even when the same temperature and access frequency are detected with respect to the plurality of memory chips, a detection result of the first memory chip CHIP 1 satisfies the first operation condition so that the power gating operation of the first memory chip CHIP 1 may be turned off while a detection result of the Nth memory chip CHIP N does not satisfy the Nth operation condition so that the power gating operation of the Nth memory chip CHIP N may be turned on.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination. Operations in the drawings may be performed in a different order to that illustrated.

While certain examples have been particularly shown and described, it will be understood that various changes in form and details may be made therein without departing from the scope of this disclosure.

## Claims

1. A memory device (200, 300, 400A, 400B, 500) comprising:
a memory cell array (210, 310) comprising one or more banks (BK1 - BKN);
a power gating switch (231, 372, 511, 521) on a power path in the memory device (200, 300, 400A, 400B, 500), the power path configured to transmit a power supply voltage (VDD, VPP) in the memory device (200, 300, 400A, 400B, 500);
a power gating controller (232, 371, 512, 522) configured to turn on or off a power gating operation of the power gating switch (231, 372, 511, 521) based on a temperature of the memory device (200, 300, 400A, 400B, 500) and a frequency of access to the memory device (200, 300, 400A, 400B, 500); and
a control logic circuit (240, 360) configured to provide, to the power gating controller (232, 371, 512, 522), temperature information (Temp) indicating the temperature of the memory device (200, 300, 400A, 400B, 500) and a counting value (CNT_A) indicating the frequency of the access,
wherein, when the power gating operation is turned on, the power gating switch (231, 372, 511, 521) is configured to toggle in response to the access to the memory device (200, 300, 400A, 400B, 500), and
when the power gating operation is turned off, the power gating switch (231, 372, 511, 521) is configured to remain turned on independent of the access to the memory device (200, 300, 400A, 400B, 500).

2. The memory device (200, 300, 400A, 400B, 500) of claim 1, wherein the control logic circuit (240, 360) includes:
a thermometer (382) configured to detect the temperature and output the temperature information (Temp), and
a counter (362) configured to perform a counting operation in response to receiving an access command, and output the counting value (CNT_A) based on the counting operation.

3. The memory device (200, 300, 400A, 400B, 500) of claim 2, wherein:
the control logic circuit (240, 360) includes a command decoder (361) configured to decode the access command and output an active command (CMD_A) for activating at least one row of the memory cell array (210, 310), and
the counter (362) is configured to count the active command (CMD_A).

4. The memory device (200, 300, 400A, 400B, 500) of claim 2 or 3, wherein:
the control logic circuit (240, 360) includes an oscillator (381) configured to output a periodic clock signal (CK), and
the counter (362) is configured to count a number of access commands during a defined number of periods of the clock signal (CK).

5. The memory device (200, 300, 400A, 400B, 500) of any one of claims 1 to 4, comprising at least one peripheral circuit (220) configured to perform a memory operation on the memory cell array (210, 310),
wherein the power path is configured to transmit the power supply voltage (VDD, VPP) to the at least one peripheral circuit (220).

6. The memory device (200, 300, 400A, 400B, 500) of claim 5, wherein:
the one or more banks (BK1 - BKN) include a first bank (BK1) and a second bank (BKN),
the at least one peripheral circuit (220) includes a first peripheral circuit corresponding to the first bank (BK1) and a second peripheral circuit corresponding to the second bank (BKN),
the power gating switch is a first power gating switch (511) configured to transmit the power supply voltage (VDD) to the first peripheral circuit, and
the memory device (200, 300, 400A, 400B, 500) comprises a second power gating switch (521) configured to transmit the power supply voltage (VDD) to the second peripheral circuit.

7. The memory device (200, 300, 400A, 400B, 500) of claim 6, wherein:
the control logic circuit (240, 360) is configured to generate a first counting value (CNT_A[1]) indicating an access frequency of the first bank (BK1) and a second counting value (CNT_A[N]) indicating an access frequency of the second bank (BKN), and
the power gating controller (512, 522) is configured to turn on the power gating operation of the first power gating switch (511) and turn off a power gating operation of the second power gating switch (521), based on the first counting value (CNT_A[1]) being different from the second counting value (CNT_A[N]).

8. The memory device (200, 300, 400A, 400B, 500) of claim 6 or 7, wherein:
the first peripheral circuit includes a first row decoder and a first column decoder for the first bank (BK1), and
the second peripheral circuit includes a second row decoder and a second column decoder for the second bank (BKN).

9. The memory device (200, 300, 400A, 400B, 500) of any one of claims 1 to 8, wherein the power gating controller (232, 371, 512, 522) is configured to turn off the power gating operation based on the temperature being lower than a first temperature reference value (T1) and the counting value (CNT_A) being greater than a first counting reference value (C1).

10. The memory device (200, 300, 400A, 400B, 500) of any one of claims 1 to 8, wherein:
the power gating controller (232, 371, 512, 522) is configured to turn off the power gating operation based on the temperature being lower than a first temperature reference value (T1), independent of the counting value (CNT_A), and
the power gating controller (232, 371, 512, 522) is configured to turn off the power gating operation based on the temperature being higher than the first temperature reference value (T1) and the counting value (CNT_A) being greater than a first counting reference value (C1), and turn on the power gating operation based on the temperature being higher than the first temperature reference value (T1) and the counting value (CNT_A) being less than the first counting reference value (C1).

11. The memory device (400A, 400B) of any one of claims 1 to 10, wherein:
the memory device (400A, 400B) includes a high bandwidth memory, HBM, and the HBM includes a first channel and a second channel configured to independently perform memory operations,
the power gating switch is a first power gating switch configured to transmit the power supply voltage in the first channel,
the memory device (400A, 400B) includes a second power gating switch configured to transmit the power supply voltage in the second channel, and
the power gating controller is configured to control the power gating operation of the first power gating switch and a power gating operation of the second power gating switch differently, in response to at least one of a temperature or a counting value of the first channel being different from a temperature or a counting value of the second channel, respectively.

12. A method of operating a memory device (200, 300, 400A, 400B, 500), the method comprising:
detecting a temperature of the memory device (200, 300, 400A, 400B, 500);
performing a counting operation on an access command provided to the memory device (200, 300, 400A, 400B, 500), to obtain a counting value (CNT_A); and
based on whether the temperature and the counting value satisfy a first condition, turning on or off a power gating operation of a power gating switch (231, 372, 511) on a power path in the memory device (200, 300, 400A, 400B, 500), wherein the power path is configured to transmit a power supply voltage (VDD, VPP) in the memory device (200, 300, 400A, 400B, 500);
wherein, when the power gating operation is turned on, the power gating switch (231, 372, 511, 521) is configured to toggle in response to receiving the access command, and
when the power gating operation is turned off, the power gating switch (231, 372, 511, 521) remains turned on independent of receiving the access command.

13. The method of claim 12, comprising, based on the temperature of the memory device (200, 300, 400A, 400B, 500) being lower than a first temperature reference value (T1) and the counting value (CNT_A) being greater than a first counting reference value (C1), turning off the power gating operation.

14. The method of claim 12, comprising:
turning off the power gating operation based on the temperature being lower than a first temperature reference value (T1), independent of the counting value (CNT_A); or
turning off the power gating operation based on the temperature being higher than the first temperature reference value (T1) and the counting value (CNT_A) being greater than a first counting reference value (C1), or turning on the power gating operation based on the temperature being higher than the first temperature reference value (T1) and the counting value (CNT_A) being less than the first counting reference value (C1).

15. The method of any one of claims 12 to 14, wherein:
the memory device (200, 300, 400A, 400B, 500) includes at least one peripheral circuit (220) configured to perform a memory operation on a memory cell array (210, 310), and
the power path is configured to transmit the power supply voltage (VDD, VPP) to the at least one peripheral circuit (220).
